# FASCICULE DE BREVET EUROPEEN

(11) **EP 3 614 156 B1**
(45) Date de publication et mention de la délivrance du brevet: **14.05.2025**
(21) Numéro de dépôt: 19192905.8
(22) Date de dépôt: 21.08.2019
(51) Int. Cl.: G01R 31/27, G01R 31/28, G01R 31/40, H03K 17/0812, H03K 17/12, H03K 17/16

(54) **CIRCUIT ÉLECTRONIQUE**
ELEKTRONISCHER SCHALTKREIS
ELECTRONIC CIRCUIT

(30) Priorité: 23.08.2018 FR 1857620
(43) Date de publication de la demande: 26.02.2020
(73) Titulaire: STMicroelectronics (Rousset) SAS, 13790 Rousset (FR)
(72) Inventeur: BIENVENU, Philippe, 83470 SAINT MAXIMIN (FR)
(74) Mandataire: Cabinet Beaumont

(56) Documents cités:
- EP-A1- 1 189 349
- EP-A1- 3 010 128
- US-A1- 2004 252 430
- US-A1- 2010 052 647

## Description

### Domaine technique

La présente demande concerne les circuits électroniques et plus particulièrement les circuits comprenant des transistors de puissance.

### Technique antérieure

Au cours de la fabrication de circuits électroniques, des tests sont effectués pour vérifier l'intégrité des circuits. Certains tests sont effectués pleine plaque, lors de la fabrication des circuits, et d'autres sont effectués en fin de fabrication, c'est-à-dire après l'assemblage des différentes parties du circuit final, y compris la mise en boîtier. Les documents EP1189349A1 (ABB RESEARCH LTD[CH]), EP3010128A1 (ROHM CO LTD [JP]), US2004/252430A1 (OUMARU TAKESHI [JP] ET AL) et US2010/052647A1 (FORGHANI-ZADEH H POOYA [US] ET AL) divulguent des exemples de circuits avec une pluralité de transistors élémentaires connectés en parallèle.

### Résumé de l'invention

Un mode de réalisation pallie tout ou partie des inconvénients des circuits électroniques usuels.

Un mode de réalisation prévoit un circuit selon la revendication 1 comprenant une pluralité de transistors élémentaires connectés en parallèle entre un noeud d'application d'un premier potentiel d'une tension d'alimentation et une charge, la pluralité de transistors comprenant un premier ensemble de transistors élémentaires dont les grilles sont couplées à un noeud de commande par un premier interrupteur, et au moins un deuxième ensemble de transistors élémentaires dont les grilles sont couplées ensemble au noeud de commande par un deuxième interrupteur, le deuxième interrupteur ayant deux états, les premier et deuxième interrupteurs étant adaptés à fournir une tension de commande sensiblement identique aux grilles des premier et deuxième ensembles de transistors élémentaires lorsque le deuxième interrupteur est dans un des deux états, dans lequel le premier interrupteur est un interrupteur maintenu fermé, de sorte que les impédances respectives entre les grilles des transistors élémentaires et le noeud de commande soient sensiblement identiques.

Selon un mode de réalisation, le rapport entre la somme des surfaces des transistors de la pluralité de transistors élémentaires et la somme des surfaces des transistors du premier ensemble de transistors élémentaires est sensiblement supérieur à 5.

Selon un mode de réalisation, les premier et deuxième interrupteurs ont sensiblement la même impédance lorsqu'ils sont fermés.

Selon l'invention, les premier et deuxième interrupteurs sont des transistors MOS.

Selon l'invention, les tensions grille/source des premier et deuxième interrupteurs sont sensiblement identiques en fonctionnement.

Selon un mode de réalisation, le circuit comprend un troisième ensemble de transistors élémentaires.

Selon un mode de réalisation, le troisième ensemble est couplé au noeud de commande par un troisième interrupteur adapté à fournir une tension de commande sensiblement identique aux tensions fournies par les premier et deuxième interrupteurs.

Selon un mode de réalisation, lors d'un test, le premier interrupteur est le seul interrupteur à être fermé, de sorte que seuls les transistors élémentaires du premier ensemble reçoivent le signal de commande.

Un mode de réalisation prévoit un procédé de test d'un circuit électronique, au cours duquel un courant traverse le premier ensemble de transistors élémentaires.

Selon un mode de réalisation, le test est effectué sous pointes.

Selon un mode de réalisation, le courant est supérieur à 2 A.

Selon un mode de réalisation, le courant ne traverse pas au moins un deuxième ensemble de transistors élémentaires.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un mode de réalisation d'un circuit électronique ; et
la figure 2 représente schématiquement une partie du circuit de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

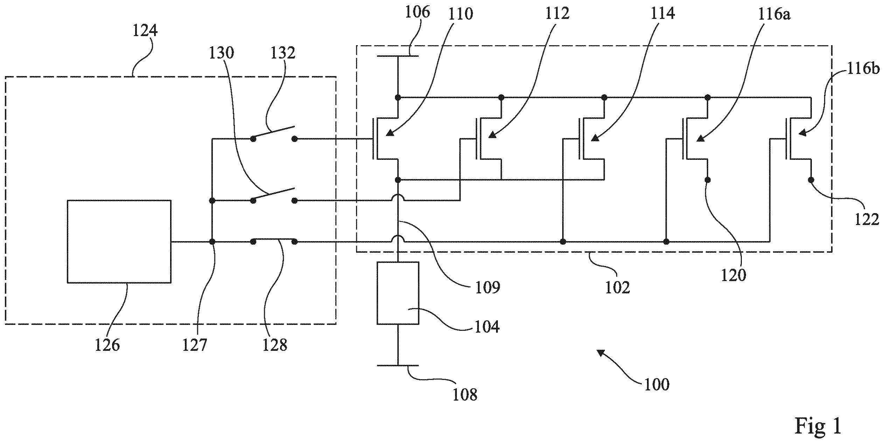

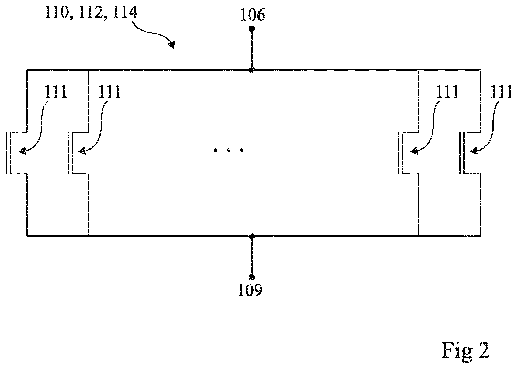

La figure 1 représente schématiquement un mode de réalisation d'un circuit électronique 100. La figure 2 représente schématiquement une partie du circuit de la figure 1.

Le circuit 100 comprend un transistor 102 de puissance couplé en série avec une charge 104 entre un noeud 106 d'application d'un premier potentiel d'une tension d'alimentation et un noeud 108 d'application d'un deuxième potentiel de cette tension. Le deuxième potentiel correspond à un potentiel de référence, par exemple la masse. Plus précisément, le transistor 102 est connecté entre le noeud 106 et un noeud 109, et la charge 104 est connectée entre le noeud 109 et le noeud 108.

Par transistor de puissance, on désigne un transistor adapté à faire passer des courants importants, par exemple supérieurs à 5 A.

Le transistor 102 comprend des transistors 110, 112 et 114 connectés en parallèle entre les noeuds 106 et 109. Plus précisément, le transistor 102 comprend une pluralité de transistors élémentaires formant les transistors 110, 112 et 114.

La figure 2 représente un des transistors 110, 112 ou 114 de la figure 1. Les transistors 110, 112 et 114 comprennent chacun un ensemble de transistors élémentaires identiques 111, connectés en parallèle entre les noeuds 106 et 109. Les grilles des transistors élémentaires d'un même ensemble sont connectées à un même noeud correspondant à la grille du transistor 110, 112 ou 114.

Selon un mode de réalisation préféré, le transistor 110 comprend un nombre de transistors élémentaires supérieur au nombre de transistors élémentaires de chaque transistor 112, 114. Le transistor 112 comprend par exemple un nombre de transistors élémentaires supérieur au nombre de transistors élémentaires du transistor 114. Par exemple, le rapport entre la somme des surfaces des transistors de la pluralité de transistors élémentaires constituant le transistor 102 et la somme des surfaces des transistors élémentaires du transistor 114 est sensiblement supérieur à 5, de préférence supérieur à 5.

Le circuit 100 comprend, de plus, un circuit de commande 124 du transistor 102. Le circuit de commande 124 comprend une pompe de charge 126 fournissant, sur un noeud de commande 127, un signal de commande du transistor 102.

Le circuit 100 comprend, en outre, des interrupteurs 128, 130 et 132, par exemple dans le circuit de commande 124. Les interrupteurs 128, 130, 132, sont respectivement couplés entre la sortie de la pompe de charge 126 et la grille des transistors 114, 112, 110. De préférence, l'interrupteur 128 est toujours fermé (passant). Par "toujours fermé", on entend toujours fermé au moins lors du fonctionnement du circuit 100.

Le composant constituant l'interrupteur 128 est de préférence un composant ayant au moins deux états, l'état bloqué et l'état passant. Le composant constituant l'interrupteur 128 est maintenu dans un de ces états (l'état passant) lors du fonctionnement du circuit.

En variante, cet interrupteur est câblé pour être normalement fermé (normally-ON).

Les composants constituant les interrupteurs 130 et 132 sont de même nature que le composant constituant l'interrupteur 128, mais sont commandés en fonction des besoins de fonctionnement du circuit 100 et ne sont donc pas systématiquement fermés, contrairement à l'interrupteur 128. Ainsi, tous les interrupteurs ont, quand ils sont à l'état passant, la même impédance série.

L'interrupteur 128 est par exemple un transistor dont la grille est reliée, de préférence connectée, à un noeud d'application d'une tension, la valeur de ladite tension permettant de maintenir l'interrupteur 128 dans un état passant (fermé). Cette tension est par exemple appliquée sur le noeud dès lors que le circuit 100 est alimenté.

Les impédances des interrupteurs 128, 130 et 132 sont par exemple sensiblement égales ou inversement proportionnelles aux surfaces des transistors auxquels ils sont connectés, lorsqu'ils sont fermés. Ainsi, les interrupteurs ont la même influence sur les différents ensembles de transistors élémentaires. En particulier, la présence de l'interrupteur 128, similaire aux interrupteurs 130 et 132, par opposition à la présence d'un élément de connexion tel qu'un fil conducteur, permet d'assurer que, en réalisant les interrupteurs 128, 130 et 132 avec des transistors, la résistance à l'état passant de tous les transistors est sensiblement la même.

Plus généralement, les impédances respectives entre les grilles des transistors élémentaires du transistor 102 et le noeud de commande 127 sont sensiblement identiques.

Les impédances des interrupteurs 128, 130 et 132 sont choisies de telle manière que les produits R*C des transistors 110, 112 et 114, où R est la résistance de l'interrupteur 128, 130 ou 132 à l'état passant et C est la capacité de grille du transistor 110, 112 ou 114, ont sensiblement la même valeur. Cela entraîne des tensions de grilles, donc des tensions grille-source, sensiblement identiques, de préférence identiques, pour tous les transistors, donc des résistances à l'état passant sensiblement identiques, donc des courants sensiblement identiques dans chaque transistor élémentaire.

Dans un premier mode de fonctionnement du circuit 100, qui correspond par exemple au mode de fonctionnement usuel du transistor de puissance 102, les interrupteurs 128, 130 et 132 sont fermés. Tous les transistors du transistor 102 sont donc commandés par le signal fourni par la pompe de charge 126.

Dans un deuxième mode de fonctionnement du circuit 100, l'interrupteur 132 est ouvert et les interrupteurs 128 et 130 sont fermés. La grille du transistor 110 ne reçoit donc pas le signal de commande. Le transistor 102 fonctionne donc comme un transistor comprenant un nombre inférieur de transistors élémentaires que le transistor 102 et supporte donc des courants inférieurs aux courants supportés par le transistor 102 dans le premier mode de fonctionnement.

Dans un troisième mode de fonctionnement du circuit 100, les interrupteurs 130 et 132 sont ouverts et l'interrupteur 128 est fermé. Les grilles des transistors 110 et 112 ne reçoivent donc pas le signal de commande. L'interrupteur 128 est donc le seul interrupteur à être fermé, de sorte que seuls les transistors élémentaires du transistor 114 reçoivent le signal de commande.

Le transistor 102 peut comprendre des transistors élémentaires 116 permettant d'obtenir des informations sur son fonctionnement, dont deux, 116a et 116b, sont représentés en figure 1. Chacun des transistors 116a et 116b est couplé entre le noeud 106 et un noeud 120 ou 122. Les tensions sur les noeuds 120 et 122 sont utilisées pour l'obtention de données représentatives de l'état du transistor 102. Les grilles des transistors 116a et 116b sont connectées à la grille du transistor 114. Les transistors 116a et 116b sont donc commandés par le même signal de commande que le transistor 114.

Les transistors 116a et 116b ne sont cependant pas parfaitement représentatifs du fonctionnement du transistor 102. En effet, les transistors 116a et 116b sont connectés entre les noeuds 106 et 109 et ne sont pas connectés à la charge 104. Certains tests doivent donc être effectués sur les autres transistors qui sont couplés entre les noeuds 106 et 108, c'est-à-dire en série avec la charge 104.

Par exemple, des tests sont effectués sur des circuits comprenant des transistors de puissance au cours desquels une première tension est fournie au noeud de commande et une deuxième tension est fournie au noeud d'alimentation de manière à faire passer un courant important, par exemple supérieur à 2 A, dans le transistor. Certaines caractéristiques des transistors sont alors mesurées. Par exemple, on peut mesurer le courant au niveau du noeud 109. Bien que ces tests soient effectués sur des composants formés sur une même plaque, ces tests sont généralement effectués en fin de fabrication, sur chaque dispositif complet. En effet, les pointes utilisées pour effectuer les tests sous pointes au cours de la fabrication ne peuvent pas supporter la chaleur provoquée par des courants importants, tels que ceux utilisés pour tester un transistor de puissance.

Le mode de réalisation de la figure 1 est compatible avec un tel test sous pointes. En effet, les inventeurs ont déterminé que les résultats d'un tel test effectué sur le transistor 114 sont représentatifs des résultats de ce même test sur le transistor 102 si la densité de courant est la même lors des deux tests. En d'autres termes, le rapport entre les courants circulant dans ces deux transistors est sensiblement égal au rapport de surface entre les transistors 114 et 102.

Le test effectué sur le transistor 114 est effectué dans le troisième mode de fonctionnement. Ainsi, les interrupteurs 130 et 132 sont ouverts. Le courant mesuré est donc bien inférieur au courant de l'application.

Par exemple, un test peut être effectué sur le circuit 100 dans le troisième mode de fonctionnement en appliquant, sur le noeud de commande, un signal de commande et, sur le noeud 106, une tension telle que le courant dans le transistor 114 atteint 2 A. Ce test est représentatif du courant circulant dans le transistor 102 en fonctionnement (premier et deuxième mode de fonctionnement) avec un coefficient de proportionnalité correspondant au rapport de surface entre les transistors 102 et 114.

A titre de variante, le transistor 102 peut ne comprendre que deux ensembles de transistors élémentaires, le transistor 114, couplé au noeud de commande par le transistor 128 fermé, et un transistor couplé au noeud de commande par un transistor pouvant être ouvert ou fermé et comprenant les transistors élémentaires des transistors 110 et 112. Le circuit 100 ne comprend alors que deux modes de fonctionnement, un premier mode, par exemple un mode de fonctionnement usuel, dans lequel les deux interrupteurs sont fermés, et un deuxième mode, correspondant au troisième mode de fonctionnement décrit précédemment, dans lequel l'interrupteur 128 est fermé et l'autre interrupteur est ouvert. Ce deuxième mode est le mode de test.

Le transistor 102 peut aussi comprendre plus de trois ensembles de transistors élémentaires couplés entre le noeud 106 et le noeud 109, chaque ensemble étant couplé au noeud de commande 127 par l'intermédiaire d'un interrupteur.

A titre de variante, les interrupteurs 128, 130 et 132 peuvent être remplacés par d'autres circuits connectant de la même manière les transistors 110, 112 et 114 au noeud de commande 127. Plus précisément, ces circuits permettent de connecter de façon commandable les grilles des transistors 110 et 112 au noeud de commande 127 et permettent de connecter la grille du transistor 114 au noeud de commande 127. Les circuits couplés aux transistors autres que le transistor 114 ont par exemple 2 états, par exemple similaires aux états passant (fermé) et bloqué (ouvert) des interrupteurs 130 et 132. Ces circuits sont adaptés à fournir, lorsqu'ils sont dans l'état similaire à l'état passant, une tension de commande sensiblement identique aux grilles des ensembles de transistors élémentaires. Par exemple, ces circuits ont une même impédance.

De préférence, le circuit 100 comprend des éléments permettant d'équilibrer les tensions de grilles pour s'assurer que les différents ensembles de transistors élémentaires reçoivent des signaux de commande identiques durant le fonctionnement. De tels éléments sont à la portée de l'homme du métier.

Un avantage des modes de réalisation décrits ici est que certains tests peuvent être effectués sous pointes sur des transistors de puissance au cours de la fabrication. Il est donc possible de déterminer les circuits défectueux avant la fin de la fabrication et de réduire ainsi les coûts de production.

Un autre avantage des modes de réalisation décrits ici est que les tests considérés sur les transistors de puissance consomment moins de courant.

Divers modes de réalisation et variantes ont été décrits. Ces divers modes de réalisation et variantes sont combinables et d'autres variantes apparaitront à l'homme de l'art. En particulier, bien que dans la description on considère que le transistor 110 a plus de transistors élémentaires que le transistor 112, et que le transistor 112 a plus de transistors élémentaires que le transistor 114, les nombres de transistors élémentaires dans les différents ensembles de transistors élémentaires peuvent être choisis autrement, tant que le nombre de transistors élémentaires du transistor 114 est adapté à la densité de courant du test à effectuer. Enfin, la mise en oeuvre pratique des modes de réalisation et variantes décrits est à la portée de l'homme du métier à partir des indications fonctionnelles données ci-dessus.

## Revendications

1. Circuit (100) comprenant une première pluralité de transistors élémentaires connectés en parallèle entre un noeud (106) d'application d'un premier potentiel d'une tension d'alimentation et une charge (104), la première pluralité de transistors comprenant un premier ensemble (114) de transistors élémentaires dont les grilles sont couplées à un noeud de commande (127) par un premier interrupteur (128), et au moins un deuxième ensemble (110, 112) de transistors élémentaires dont les grilles sont couplées ensemble au noeud de commande (127) par un deuxième interrupteur (130, 132), le deuxième interrupteur ayant deux états, le circuit étant adapté à fournir en sortie des premier et deuxième interrupteurs une tension de commande sensiblement, c'est-à-dire à 10 % près, identique aux grilles des premier et deuxième ensembles de transistors élémentaires lorsque le deuxième interrupteur est dans un des deux états, les premier et deuxième interrupteurs (110, 112) étant des transistors MOS, les tensions grille-source des premier et deuxième interrupteurs étant sensiblement identiques en fonctionnement, dans lequel le premier interrupteur (128) est un interrupteur toujours maintenu fermé au moins lors du fonctionnement du circuit 100, de sorte que les impédances respectives entre les grilles des transistors élémentaires de chacun des premier (114) et deuxième (110, 112) ensembles et le noeud de commande (127) soient sensiblement identiques, les premier (128) et deuxième interrupteurs (110, 112) ayant sensiblement la même impédance lorsqu'ils sont fermés,
le circuit comprenant une deuxième pluralité de transistors élémentaires, chaque transistor de la deuxième pluralité comprenant une borne de commande reliée au noeud de commande (127) par le premier interrupteur (128), une première borne de conduction reliée au noeud (106) d'application du premier potentiel d'une tension d'alimentation et une deuxième borne de conduction reliée à un noeud de test (120,122).

2. Circuit selon la revendication 1, dans lequel le rapport entre la somme des surfaces des transistors de la première pluralité de transistors élémentaires (102) et la somme des surfaces des transistors du premier ensemble (114) de transistors élémentaires est sensiblement supérieur à 5.

3. Circuit selon la revendication 1 ou 2, comprenant un troisième ensemble (112, 110) de transistors élémentaires.

4. Circuit selon la revendication 3, dans lequel le troisième ensemble (112, 110) est couplé au noeud de commande par un troisième interrupteur (130) adapté à fournir une tension de commande sensiblement identique aux tensions de commande fournies par les premier (128) et deuxième interrupteurs (132).

5. Circuit selon l'une quelconque des revendications 1 à 4, dans lequel, lors d'un test, le premier interrupteur (128) est configuré pour être le seul interrupteur à être fermé, de sorte que seuls les transistors élémentaires du premier ensemble reçoivent un signal de commande (127).

6. Procédé de test d'un circuit électronique (100) selon l'une quelconque des revendications 1 à 5, au cours duquel un courant traverse le premier ensemble (114) de transistors élémentaires.

7. Procédé selon la revendication 6, dans lequel le test est effectué sous pointes.

8. Procédé selon la revendication 6 ou 7, dans lequel le courant est supérieur à 2 A.

9. Procédé selon l'une quelconque des revendications 6 à 8, dans lequel le courant ne traverse pas au moins un deuxième ensemble (110, 112) de transistors élémentaires.

## Patentansprüche

1. Schaltung (100), die eine erste Vielzahl von Elementartransistoren aufweist, die parallel zwischen einem Knoten (106) zum Anlegen eines ersten Potentials einer Stromversorgungsspannung und einer Last (104) geschaltet sind, wobei die erste Vielzahl von Transistoren eine erste Anordnung (114) von Elementartransistoren, deren Gates durch einen ersten Schalter (128) mit einem Steuerknoten (127) gekoppelt sind, und mindestens eine zweite Anordnung (110, 112) von Elementartransistoren aufweist, deren Gates durch einen zweiten Schalter (130, 132) mit dem Steuerknoten (127) gekoppelt sind, wobei der zweite Schalter zwei Zustände aufweist, wobei die Schaltung konfiguriert ist um am Ausgang der ersten und zweiten Schalter eine im Wesentlichen, d. h. plus oder minus 10 %, identischen Steuerspannung an die Gates der ersten und der zweiten Anordnung von Elementartransistoren anzulegen, wenn sich der zweite Schalter in einem der beiden Zustände befindet, wobei die ersten und zweiten Schalter (110, 112) MOS-Transistoren sind, die Gate-Source-Spannungen der ersten und zweiten Schalter im Betrieb im Wesentlichen identisch sind, wobei der erste Schalter (128) ein Schalter ist, der zumindest während des Betriebs der Schaltung 100 immer in einem eingeschalteten Zustand gehalten wird, so dass die jeweilige Impedanz zwischen den Gates der Elementartransistoren jeder der ersten (114) und zweiten (110, 112) Anordnungen und dem Steuerknoten (127) identisch ist, wobei die ersten (128) und zweiten Schalter (110, 112) im Wesentlichen die gleiche Impedanz aufweisen, wenn sie eingeschaltet sind,
wobei die Schaltung eine zweite Vielzahl von Elementartransistoren aufweist, wobei jeder Transistor der zweiten Vielzahl einen Steueranschluss, der durch den ersten Schalter (128) mit dem Steuerknoten (127) gekoppelt ist, einen ersten leitenden Anschluss, der mit dem Knoten (106) zum Anlegen eines ersten Potentials einer Stromversorgungsspannung gekoppelt ist, und einen zweiten leitenden Anschluss, der mit einem Testknoten (120, 122) gekoppelt ist, aufweist.

2. Schaltung nach Anspruch 1, wobei das Flächenverhältnis zwischen der Summe der Flächen der Transistoren der ersten Vielzahl von Elementartransistoren (102) und der Summe der Flächen der Transistoren der ersten Anordnung (114) von Elementartransistoren wesentlich größer als 5 ist.

3. Schaltung nach Anspruch 1 oder 2, aufweisend eine dritte Anordnung (112, 110) von Elementartransistoren.

4. Schaltung nach Anspruch 3, wobei die dritte Anordnung (112, 110) mit dem Steuerknoten durch einen dritten Schalter (130) verbunden ist, der eine Steuerspannung liefern kann, die im Wesentlichen identisch mit den Steuerspannungen ist, die durch die ersten (128) und zweiten Schalter (132) geliefert werden.

5. Schaltung nach einem der Ansprüche 1 bis 4, wobei während eines Tests der erste Schalter (128) so konfiguriert ist, dass er der einzige eingeschaltete Schalter ist, so dass nur die Elementartransistoren der ersten Anordnung ein Steuersignal (127) empfangen.

6. Verfahren zum Testen der elektronischen Schaltung (100) nach einem der Ansprüche 1 bis 5, bei dem ein Strom durch die erste Anordnung (114) von Elementartransistoren fließt.

7. Verfahren nach Anspruch 6, wobei der Strom unter Sonden angelegt wird.

8. Verfahren nach Anspruch 6 oder 7, wobei der Strom größer als 2 A ist.

9. Verfahren nach einem der Ansprüche 6 bis 8, wobei der Strom nicht durch mindestens eine zweite Anordnung (110, 112) von Elementartransistoren fließt.

## Claims

1. A circuit (100) comprising a first plurality of elementary transistors connected in parallel between a node (106) of application of a first potential of a power supply voltage and a load (104), the first plurality of transistors comprising a first assembly (114) of elementary transistors having their gates coupled to a control node (127) by a first switch (128) and at least a second assembly (110, 112) of elementary transistors having their gates coupled to the control node (127) by a second switch (130, 132), the second switch having two states, the circuit being configured to provide in output of the first and second switches a substantially, meaning plus or minus 10%, identical control voltage to the gates of the first and second assemblies of elementary transistors when the second switch is in one of the two states, the first and second switches (110, 112) being MOS transistors, the gate-source voltages of the first and second switches being substantially identical in operation, wherein the first switch (128) is a switch always maintained in an on state at least during the operation of the circuit 100, so that the respective impedance between the gates of the elementary transistors of each of the first (114) and second (110, 112) assemblies and the control node (127) are identical, the first (128) and second switches (110, 112) having substantially the same impedance when they are on, the circuit comprising a second plurality of elementary transistors each transistor of the second plurality comprising a control terminal coupled to the control node (127) by the first switch (128), a first conductive terminal coupled to the node (106) of application of a first potential of a power supply voltage and a second conductive terminal coupled to a test node (120, 122).

2. The circuit of claim 1, wherein the surface area ratio between the sum of the areas of the transistors of the first plurality of elementary transistors (102) and the sum of the areas of the transistors of the first assembly (114) of elementary transistors is substantially greater than 5.

3. The circuit of claim 1 or 2, comprising a third assembly (112, 110) of elementary transistors.

4. The circuit of claim 3, wherein the third assembly (112, 110) is coupled to the control node by a third switch (130) capable of supplying a control voltage substantially identical to the control voltages supplied by the first (128) and second switches (132).

5. The circuit of any of claims 1 to 4, wherein, during a test, the first switch (128) is configured to be the only on switch, so that only the elementary transistors of the first assembly receive a control signal (127).

6. A method of testing the electronic circuit (100) of any of claims 1 to 5, during which a current flows through the first assembly (114) of elementary transistors.

7.The method of claim 6, wherein the current is applied under probes.

8. The method of claim 6 or 7, wherein the current is greater than 2 A.

9. The method of any of claims 6 to 8, wherein the current does not flow through at least one second assembly (110, 112) of elementary transistors.
